Europäisches Patentamt

European Patent Office

Office européen des brevets

(19)

(11) Numéro de publication : **0 484 216 A1**

## (12) DEMANDE DE BREVET EUROPEEN

(21) Numéro de dépôt : **91402863.4**

(22) Date de dépôt : **25.10.91**

(51) Int. Cl.⁵ : **H05K 7/02**, B60R 16/02

(30) Priorité : **29.10.90 FR 9013382**

(43) Date de publication de la demande :
**06.05.92 Bulletin 92/19**

(84) Etats contractants désignés :
**DE ES GB IT SE**

(71) Demandeur : **SOURIAU ET CIE**
**145, rue Yves-Le-Coz**
**F-78035 VERSAILLES CEDEX (FR)**

(72) Inventeur : **Le Bris, Henri**
**72 Avenue Pierre Vermeir**
**F-92160 Antony (FR)**
Inventeur : **Bonnetier, Marie-Noelle**
**15, Rond Point des Martyrs**
**F-92220 Bagneux (FR)**

(74) Mandataire : **Fort, Jacques**
**CABINET PLASSERAUD 84, rue d'Amsterdam**
**F-75009 Paris (FR)**

(54) **Boîte de distribution et procédé de fabrication d'une telle boîte.**

(57) La boîte de distribution, utilisable notamment sur un attelage routier, comporte un boîtier constitué de deux flasques accolés (10,12) et remplis d'un matériau isolant d'enrobage. Le boîtier porte des embases de connecteur (18,20) sur deux grandes faces. Il contient un circuit imprimé porté par deux cartes (28,30) placées dos à dos et reliées par un circuit souple de liaison (32). Les contacts de connecteurs (24) et éventuellement de porte-fusibles (34) sont soudés à la vague sur les cartes.

FIG.2.

EP 0 484 216 A1

La présente invention concerne les boîtes de distribution du type ayant un boîtier portant des embases de connecteurs d'entrée et de sortie sur deux grandes faces et contenant un circuit imprimé interne de liaison entre les embases, permettant de relier les uns aux autres les contacts des connecteurs d'entrée et de sortie suivant une répartition déterminée par la constitution du circuit interne.

L'invention trouve une application particulièrement importante, bien que non exclusive, dans les attelages et notamment dans les attelages routiers ayant un tracteur et une remorque ou semi-remorque. Dans de tels attelage, on utilise une boîte de distribution pour répartir entre différents emplacements, les informations arrivant par un ou plusieurs connecteurs d'entrée. Les informations, telles que des courants envoyés à des appareils d'éclairage, sortent de la boîte par les connecteurs de sortie alimentant des câbles distincts.

A l'heure actuelle, on utilise en particulier des boîtes de distribution ayant un circuit porté par une carte imprimée double face et des embases surmoulées dans un matériau isolant. Si les contacts des embases de connecteurs placés sur un côté de la carte peuvent être raccordés aisément en utilisant le procédé économique de soudage à la vague, les contacts placés de l'autre côté doivent être soudés manuellement, ce qui se traduit par un coût de réalisation élevé. De plus, les boîtes de distribution connues sont dépourvues de fusibles, ce qui contraint à se fier aux fusibles généraux montés sur le véhicule tracteur, aux dépens de la sécurité et de la facilité de repérage d'un circuit défectueux.

La présente invention vise à fournir une boîte de distribution présentant un coût inférieur à celui des boîtes actuelles pour remplir les mêmes fonctions et/ou permettant de remplir davantage de fonctions à un coût comparable ou inférieur.

Dans ce but, l'invention propose notamment une boîte de distribution du type ci-dessus défini, caractérisée en ce que le boîtier est constitué de deux flasques accolés et remplis d'un matériau isolant d'enrobage et en ce que le circuit imprimé interne porte sur une face des porte-fusibles accessibles depuis l'extérieur du boîtier par une ouverture d'un des flasques, obturable par un capot amovible en vue de permettre le remplacement aisé des fusibles.

Le circuit imprimé peut être simple face, double face ou même souple (type " Ben Flex " par exemple). Les porte-fusibles sont avantageusement placés d'un seul côté de la carte, vers l'un des flasques seulement.

Cette disposition permet d'affecter un fusible à chacun des circuits alimentés, de repérer facilement un circuit défectueux et de remplacer de façon simple le fusible qui est intervenu, après remise en état du circuit défectueux.

L'invention propose également une boîte de distribution du type ci-dessus défini, caractérisée en ce que le circuit imprimé interne est porté par deux cartes simple face placées dos à dos et reliées par un circuit souple de liaison et en ce que les contacts des connecteurs (et éventuellement de porte-fusibles) placés du seul côté qui porte le circuit imprimé des cartes, sont soudés dans des trous métallisés des cartes.

Cette constitution permet d'effectuer toutes les jonctions électriques requises par le procédé économique de soudage à la vague.

L'invention sera mieux comprise à la lecture de la description qui suit d'une boîte de distribution constituant un mode particulier de réalisation de l'invention, donné à titre d'exemple non limitatif. La description se réfère aux dessins qui l'accompagnent, dans lesquels :
- la figure 1 est une vue de face d'une boîte de distribution, le capot de protection des fusibles étant enlevé, ainsi que les fusibles et porte-fusibles ;
- la figure 2 est une vue en coupe suivant la ligne II-II de la figure 1, un seul fusible étant montré ;
- la figure 3 est une vue d'arrière de la boîte ;
- la figure 4 est une vue en coupe suivant la ligne IV-IV de la figure 3.

La boîte de distribution montrée sur les figures est notamment utilisable pour distribuer à des câbles les informations, sous forme électrique, amenées par un câble d'entrée. Une telle boîte de distribution est en particulier utilisable sur une remorque pour amener des courants électriques de niveau quelconque à des emplacements différents, la répartition étant déterminée par la constitution du circuit imprimé que comporte la boîte. Cette dernière peut comporter, en plus de moyens de distribution électriques, des moyens de distribution de signaux optiques à des câbles à fibres optiques.

La boîte est de forme plate. Elle a un boîtier constitué de deux flasques 10 et 12 approximativement rectangulaires, ayant des rebords à emboîtement permettant d'assembler les flasques et de définir une cavité étanche à l'écoulement. Les deux flasques sont avantageusement retenus l'un sur l'autre par des pinces élastiques 14 solidaires d'un flasque et s'encliquetant sur l'autre. Des trous 16 permettent de fixer la boîte de distribution.

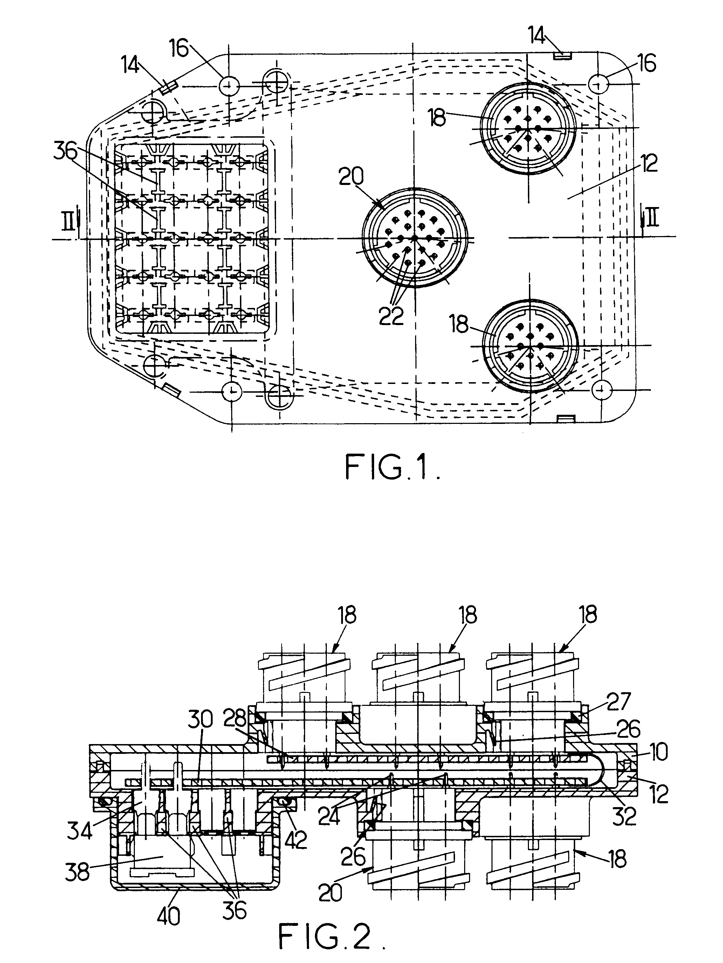

Les deux flasques présentent des bossages tubulaires en saillie vers l'extérieur, destinés chacun à recevoir une embase de connecteur. Pour des raisons d'économie, l'embase peut être constituée par un corps en matériau thermo-plastique (polybutylène chargé par exemple) dans lequel des contacts 22 en alliage cuivreux usinés sont fixés par emmanchement, aussi bien pour les embases de connecteurs de sortie 18 que pour celle du connecteur d'entrée 20. Chacun de ces contacts se prolonge, vers l'intérieur du boîtier, par un picot tel que ceux indiqués en 24 sur la figure 2. Lorsque, ce qui est le cas général, le boîtier est destiné à être rempli d'un matériau d'enrobage solidifié, les corps d'embase peuvent être simplement retenus par des pattes élastiques 26 jusqu'à achèvement du montage de la boîte.

Un joint d'étanchéité annulaire 27 est interposé entre une collerette de chaque embase et un épaulement du bossage qui la reçoit, pour assurer l'étanchéité. Ce joint est maintenu en compression par les pattes élastiques 26 de retenue de l'embase. Les connecteurs sont avantageusement du type à bague de verrouillage par rampe hélicoïdale à grand pas, avec encliquetage ou point dur de sécurité en fin de course. On peut par exemple utiliser des connecteurs du type décrit dans le document EP-A-0 346 234.

Le boîtier contient un circuit imprimé porté par deux cartes simple face 28 et 30 placées dos à dos et reliées par un circuit souple 32 muni de contacts d'extrémité soudables sur les cartes. C'est la constitution des circuits imprimés et du circuit souple qui fixe la distribution des informations électriques reçues du connecteur d'entrée entre les connecteurs de sortie.

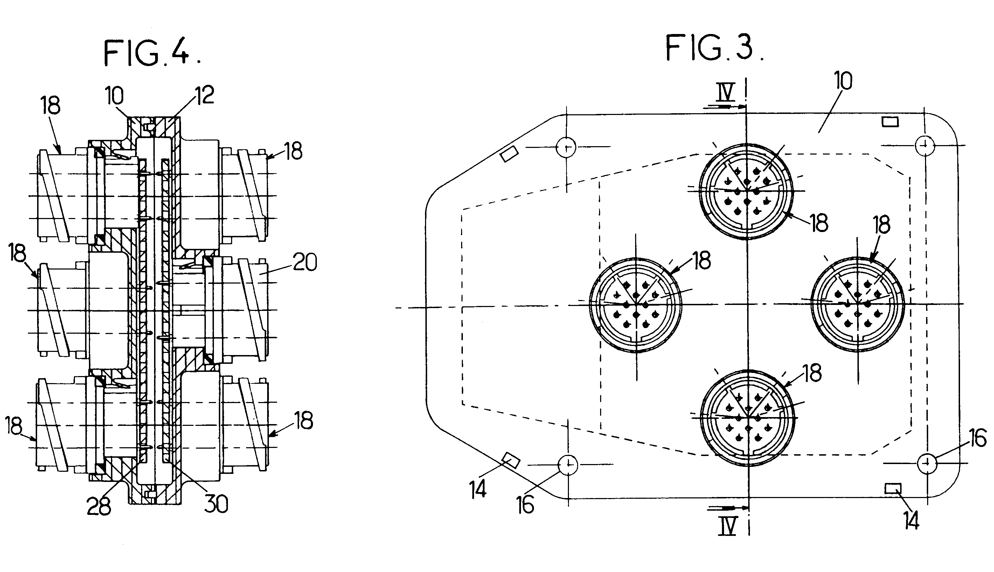

Dans le mode de réalisation montré en figures 1 à 4, les deux cartes ont des longueurs différentes. Cela facilite le montage, sur la partie de la carte la plus longue 30 qui déborde de la carte la plus courte 28, de porte-fusibles 34. L'ouverture est avantageusement fractionnée par des cloisons 36, de façon à séparer les porte-fusibles les uns des autres dans un but de sécurité et à en assurer la rétention avant soudage.

Cette disposition permet de placer des fusibles 38 accessibles de l'extérieur sous un capot de fermeture 40 fixé par des moyens non représentés, tels qu'une vis centrale. Un joint d'étanchéité 42 interposé entre le capot 40 et le flasque 12 assure l'étanchéité de la boîte.

La boîte peut être fabriquée par le procédé suivant.

Les flasques 10 et 12 sont réalisés en matériau isolant, généralement en un matériau thermo-plastique qui n'a pas besoin d'être aussi noble que celui constituant les corps d'embase. Les embases 18 et 20 munies de leur joint d'étanchéité 27 sont enfoncées jusqu'à ce qu'elles soient retenues par encliquetage des pattes élastiques 26. Les porte-fusibles 34 sont mis en place à travers l'ouverture ménagée dans le flasque 12 (le capot 40 étant enlevé). Les deux cartes de circuit imprimé 28 et 30 sont mises à plat et les flasques 10 et 12 sont montés séparément sur les cartes de façon que les picots des embases et des porte-fusibles qu'ils portent traversent les trous prévus à cet effet dans les cartes 28 et 30.

L'ensemble ainsi constitué est soudé à la vague : on fixe ainsi en une seule fois les picots 24 des embases et les picots des porte-fusibles 34 ; le circuit souple 32 peut être monté séparément ou ses contacts peuvent eux aussi être soudés à la vague.

Une fois le soudage terminé, on rabat les deux flasques 10 et 12, contenant chacun une carte, l'un sur l'autre à la manière d'un portefeuille et on les emboîte en vérifiant que les pinces ou doigts de verrouillage 14 sont bien en place.

Pour rendre la boîte étanche, on peut noyer les contacts intérieurs à l'aide d'un produit d'enrobage isolant durcissable. Au cours d'une première étape, le boîtier peut être tenu en position verticale et le produit d'enrobage versé à l'état liquide jusqu'en haut de la carte la plus courte. Puis le boîtier est mis à plat et l'enrobage est complété, en évitant de déborder sur les porte-fusibles.

On constitue ainsi un ensemble monobloc, extrêmement robuste, aussi résistant aux infiltrations et aux projections d'eau qu'une boîte à surmoulage direct des contacts, à un coût bien inférieur. On peut notamment obtenir sans difficulté l'étanchéité au jet d'eau sous une pression de 150 bars requise pour les applications automobiles.

L'invention ne se limite pas au mode particulier de réalisation qui a été représenté et décrit à titre d'exemple. De nombreuses variantes sont possibles, aussi bien en ce qui concerne la nature des connecteurs que l'application de la boîte.

## Revendications

1. Boîte de distribution comportant un boîtier équipé d'embases de connecteur d'entrée et de sortie (18,20) sur deux grandes faces et un circuit imprimé interne de liaison entre les contacts des embases, caractérisée en ce que le boîtier est constitué de deux flasques (10 et 12) accolés et remplis d'un matériau isolant d'enrobage et en ce que les circuits imprimés comportent, sur une face, des porte-fusibles (34) accessibles depuis l'extérieur par une ouverture d'un des flasques (12) obturable par un capot (40) amovible de recouvrement des fusibles (38).

2. Boîte de distribution selon la revendication 1, caractérisée en ce que l'ouverture est fractionnée par des cloisons (36) appartenant à un des flasques (12) et séparant les porte-fusibles.

3. Boîte de distribution comportant un boîtier équipé d'embases de connecteur d'entrée et de sortie (18,20) sur deux grandes faces et un circuit imprimé interne de liaison entre les contacts des embases, caractérisée en ce que le circuit imprimé est porté par deux cartes simple face (28,30) placées dos à dos et reliées par un circuit souple de liaison (32), les contacts des embases étant soudés sur lesdites cartes.

4. Boîte de distribution selon la revendication 3, caractérisée en ce que des porte-fusibles sont soudés sur une des deux cartes (28,30) à un emplacement accessible depuis l'extérieur par une ouverture d'un des flasques (12) obturable par un capot (40) amovible de recouvrement étanche de fusibles (38).

5. Boîte de distribution selon la revendication 4, caractérisée en ce que les porte-fusibles sont soudés sur une portion d'une des cartes (30) qui déborde de l'autre carte (28) à l'opposé du circuit souple de liaison (32).

6. Boîte selon la revendication 3, 4 ou 5, caractérisée en ce que les embases sont retenues sur les flasques et en ce que les contacts traversent les cartes et sont fixés au circuit imprimé par soudage sur la face de la carte tournée vers l'intérieur.

7. Boîte selon l'une quelconque des revendications précédentes, caractérisée en ce que chaque embase est montée dans un bossage tubulaire d'un flasque correspondant et retenue par des doigts élastiques (26) pouvant appartenir aux flasques ou aux embases dans une position de maintien en compression d'un joint d'étanchéité (7) interposé entre une collerette de l'embase et le flasque.

8. Boîte selon l'une quelconque des revendications précédentes, caractérisée par des pinces ou doigts élastiques (14) solidaires d'un flasque et s'encliquetant sur l'autre pour retenir les flasques en position assemblée.

9. Procédé de fabrication d'une boîte de distribution selon la revendication 3 ou l'une quelconque des revendications qui en dépendent, caractérisé en ce que les embases (18,20) munies d'un joint d'étanchéité sont enfoncées dans les flasques jusqu'à une position de retenue ; les flasques (10,12) sont montés sur les cartes (28,30) mises à plat de façon que les picots des contacts d'embases traversent des trous dans les cartes, l'ensemble est soudé à la vague et les flasques sont rabattus l'un sur l'autre et fixés.

10. Procédé selon la revendication 9, caractérisé en ce que l'on remplit le boîtier d'un produit d'enrobage isolant, à l'exclusion de la zone des porte-fusibles éventuels.

FIG.1.

FIG.2.

FIG. 3.

FIG. 4.

Office européen
des brevets

**RAPPORT DE RECHERCHE EUROPEENNE**

Numero de la demande

EP 91 40 2863

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | DE-A-3 048 451 (KABELWERKE REINSHAGEN GmbH) <br> * Page 9, alinéa 3 – page 11, dernier alinéa; figures 1,2 * | 1-3 | H 05 K 7/02 <br> B 60 R 16/02 |
| A | DE-A-3 908 481 (TRW MESSMER GmbH) <br> * Colonne 4, lignes 41-68; figure 1 * | 1 | |
| A | DE-C-3 744 603 (FRANZ KIRSTEN ELEKTROTECHNISCHE SPEZIALFABRIK) <br> * Colonne 5, ligne 29 – colonne 6, ligne 34; figures 1,2 * | 1 | |
| A | GB-A- 749 872 (THE GENERAL ELECTRIC CO., LTD) <br> * Page 3, lignes 37-63; figures 2,3 * | 1 | |
| Y | EP-A-0 388 058 (YAZAKI) <br> * Colonne 2, lignes 32-48; figure 1 * | 1 | |
| P,Y | DE-A-4 039 537 (YAZAKI) <br> * Colonne 1, lignes 9-14; figures 8,9 * | 1 | DOMAINES TECHNIQUES RECHERCHES (Int. Cl.5) <br><br> H 05 K <br> B 60 R <br> H 01 H |

Le présent rapport a été établi pour toutes les revendications

| Lieu de la recherche | Date d'achèvement de la recherche | Examinateur |
|---|---|---|
| LA HAYE | 20-02-1992 | LUND M. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)